Europäisches Patentamt

European Patent Office

Office européen des brevets

(11) Publication number: **0 066 721**
**B1**

(12) **EUROPEAN PATENT SPECIFICATION**

(45) Date of publication of patent specification: **01.04.87**

(21) Application number: **82104076.3**

(22) Date of filing: **11.05.82**

(51) Int. Cl.⁴: **H 01 L 29/743,** H 01 L 29/10,
H 01 L 29/08

(54) **Gate turn-off thyristor.**

(30) Priority: **15.05.81 JP 73791/81**

(43) Date of publication of application:
**15.12.82 Bulletin 82/50**

(45) Publication of the grant of the patent:
**01.04.87 Bulletin 87/14**

(84) Designated Contracting States:
**CH DE FR GB LI NL**

(56) References cited:
**EP-A-0 009 367**
**EP-A-0 014 098**
**EP-A-0 022 355**

(73) Proprietor: **Hitachi, Ltd.**
**5-1, Marunouchi 1-chome**
**Chiyoda-ku Tokyo 100 (JP)**

(72) Inventor: **Nagano, Takahiro**
**2693-5, Kanesawacho**
**Hitachi-shi (JP)**
Inventor: **Yatsuo, Tsutomu**
**28-7, Mizukicho-2-chome**
**Hitachi-shi (JP)**
Inventor: **Oikawa, Saburo**
**40-15, Kujicho-5-chome**
**Hitachi-shi (JP)**
Inventor: **Fukui, Hiroshi**
**1045, Moriyamacho**
**Hitachi-shi (JP)**
Inventor: **Kimura, Shin**
**1404-7, Ishinazakacho**
**Hitachi-shi (JP)**

(74) Representative: **Patentanwälte Beetz sen. -**
**Beetz jun. Timpe - Siegfried - Schmitt-Fumian**
**Steinsdorfstrasse 10**
**D-8000 München 22 (DE)**

**Description**

This invention relates to gate turn-off thyristors and particularly to the junction structure of a gate turn-off thyristor (hereinafter, referred to as the GTO thyristor).

The thyristor consisting of 4 layers of pnpn has an advantage that it can control a large electric power as compared with the transistor consisting of three layers of pnp or npn, but has also a defect that it cannot be restored from the on-state to the off-state by only a gate signal.

Thus, a junction structure has been devised of the cathode emitter layer where the cathode electrode is provided, the first base layer which is adjacent to the cathode emitter layer and at which the control electrode is provided, and the second layer which is adjacent to the first base layer and at which the control electrode is not provided, so that the GTO thyristor has been realized which can be turned off by only the gate signal.

More specifically, the width of the cathode emitter layer is reduced and surrounded by the control electrode, the lateral resistance of the second base layer beneath the cathode emitter layer is reduced to permit the gate signal to reach the center of the cathode emitter layer, and in the on-condition, the amount of carriers accumulated on the second base layer is reduced so that the gate current necessary for turning off or the amount of the charge drawn through the gate can be decreased. To decrease the amount of accumulated charges, a life time killer such as gold is doped (as disclosed in the Japanese Patent Publication No. 31876/1972), or the anode emitter layer and the second base layer are connected to the anode electrode in ohmic contact, i.e., the so-called anode emitter shorting structure (the Japanese Patent Publication No. 10143/1980) is used.

When the GTO thyristor is used for a main switching element in a power converter such as an inverter, there is no problem in normal operation, but the current is extremely increased upon occurrence of a shorted load, a shorted thyristor-arm or the like because the GTO thyristor has no current limiting action. As a result, the current to be cut off in the GTO thyristor becomes very large, and cutting off the current exceeding the limit will fail to turn off the GTO thyristor, resulting in the permanent break-down of the thyristor. Therefore, in the prior art, a snubber circuit having a diode, a resistor and a capacitor is connected in parallel with the GTO thyristor, thereby preventing the GTO thyristor from failing to be turned off. This results in a complicated circuit arrangement of a large size.

Accordingly, it is an object of this invention to provide a GTO thyristor which requires no snubber circuit, and which can be used in a simple and small-sized circuit.

It is another object of this invention to provide a GTO thyristor which requires no snubber circuit and which has a satisfactory switching characteristic.

These objects are achieved according to the invention by a gate turn-off thyristor comprising:

a) a semiconductor substrate (1) in which a cathode emitter layer (5), a first base layer (4), a second base layer (3) and an anode emitter layer (2) are formed, in which these other, adjacent ones of said layers are having different conductivity from each other to form pn junctions therebetween;

b) said cathode emitter layer (5) being divided into cathode emitter layer portions each of which is exposed at one of the main surfaces of said semiconductor substrate (1);

c) said anode emitter layer (2) being exposed at the other main surface of said semiconductor substrate (1);

d) each of said separated cathode emitter layer portions (5) being made in low resistive contact with a cathode electrode (9);

e) said first base layer (4) being made in low resistive contact with a control electrode (8) formed to surround each of said separated cathode emitter layer portions (5); and

f) said anode emitter layer (2) being made in low resistive contact with an anode electrode (7); characterized in

that said second base layer (3) having a thickness $W_{nB}[\mu m]$ determined by the following condition:

$$3.817 \times 10^{-1} \cdot V_{BO} - 2.550 \times 10^{-4} \cdot V_{BO}^{2} + 1.133 \times 10^{-7} \cdot V_{BO}^{3}$$

$$-2.000 \times 10^{-11} \cdot V_{BO}^{4} \leq W_{nB} \leq 3.200 \times 10^{-1} \cdot V_{BO}$$

where $V_{BO}[V]$ is a breakover voltage given when the anode electrode (7) and the cathode electrode (9) are supplied with a positive and a negative bias voltage, respectively.

This invention will become more readily understood from the following exemplary description with reference to the accompanying drawings, in which:.

Fig. 1 is a graph showing the safety operation region upon turn-off switching of the GTO thyristor;

Fig. 2 is a graph showing a characteristic required for the GTO thyristor;

Fig. 3 is a connection diagram of a conventional snubber circuit;

Fig. 4 is a graph for the design of the GTO thyristor according this invention;

Fig. 5 is a cross-section of a unit GTO thyristor of the GTO thyristor according to this invention;

Fig. 6 is a plan of the anode side showing one embodiment of this invention;

Fig. 7 is a cross-section of a unit GTO thyristor used in another embodiment of this invention; and

Fig. 8 is a cross-section of a unit GTO thyristor used in still another embodiment of this invention.

The inventors, after detailed examination of the turn-off breakdown phenomenon in the GTO thyristor have found that unless the locus of the instantaneous value of each of the anode-cathode voltage and anode current upon turn-off switching of the GTO thyristor exceeds a limit line, the turn-off operation is successfully performed.

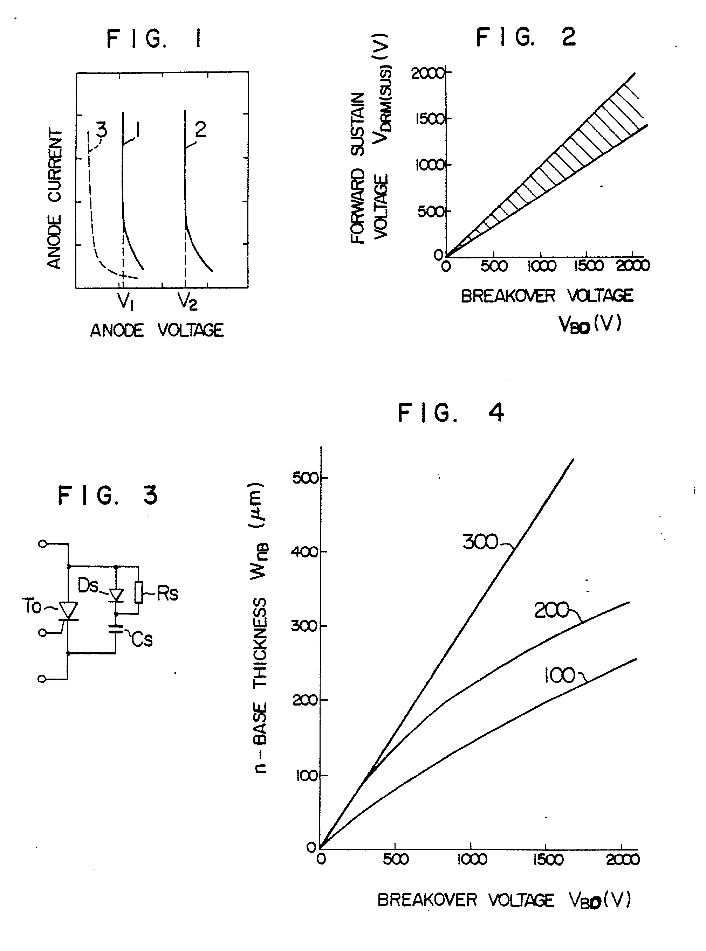

In Fig. 1, each of the curves 1 and 2 shows, as an envelope, the locus of instantaneous values of different anode voltages and currents of a GTO thyristor which were obtained when the GTO thyristor could be turned off. The curves 1 and 2 show the envelope obtained with respect to two different GTO thyristors. Within each envelope, the GTO thyristor can be operated with safety. Namely, the curves 1 and 2 are the limit lines within which the respective GTO thyristors can be turned off.

As shown in Fig. 1, the anode voltage is substantially constant in the region in which the anode current is large, but tails in a skirt in the region in which the anode current is small. The constant voltage ($V_1$ and $V_2$ in Fig. 1) before the tail of skirt is called as a forward sustain voltage here.

The forward sustain voltage $V_{DRM(SUS)}$ never exceeds the forward blocking voltage or breakover voltage $V_{BO}$. In order to make the GTO thyristor operative in itself, or with substantially no snubber circuit, it is necessary that the forward sustain voltage $V_{DRM(SUS)}$ be about 67% or above 67% of the breakover voltage $V_{BO}$. Therefore, the GTO thyristor needs to have the relation between the breakover voltage $V_{BO}$ and the forward sustain voltage as shown in the shaded area in Fig. 2. When the breakover voltage $V_{BO}$ is, for example, 600V, the forward sustain voltage $V_{DRM(SUS)}$ must be 400 to 600V.

The greatest problem what the conventional GTO thyristor has is its very low forward sustain voltage as compared with the forward blocking voltage or breakover voltage. For example, when the breakover voltage of a conventional GTO thyristor is 600V, the forward sustain voltage of this thyristor is only 150 to 200V.

Thus, since the conventional GTO thyristor itself does not satisfy the above condition, for example, a snubber circuit constituted by a diode $D_s$, a resistor $R_s$ and a capacitor $C_s$ is connected in parallel with a GTO thyristor $T_o$ as shown in Fig. 3 to cause the voltage-current locus upon turn-off to follow the curve 3 in Fig. 1.

In order to achieve the above objects, the inventors have examined in detail the GTO thyristor exhibiting the curves 1 and 2 in Fig. 1 and as a result found that the forward sustain voltage depends on the thickness of the second base layer constituting the GTO thyristor.

In Fig. 4, the curve 100 shows the relation between the $W_{nB}$ and $V_{BO}$ of a normal GTO thyristor with a snubber circuit. The curve 200 shows the relation between the thickness $W_{nB}$ of the second base layer 3 and the breakover voltage $V_{BO}$ with substantially no snubber circuit, as given by

$$W_{nB}=3.817\times10^{-1} \cdot V_{BO}-2.550\times10^{-4} \cdot V_{BO}^2$$

$$+1.133\times10^{-7} \cdot V_{BO}^3-2.000\times10^{-11} \cdot V_{BO}^4 \tag{1}$$

The thickness $W_{nB}$ of the second base layer is the distance from the pn junction formed between the anode emitter layer and the second base layer to the pn junction formed between the second base layer and the first base layer, measured along the direction from the anode electrode toward the cathode electrode.

The curve 300 shows the relation between the $W_{nB}$ and $V_{BO}$ with no snubber circuit as given by

$$W_{nB}=3.200\times10^{-1} \cdot V_{BO} \tag{2}$$

where $W_{nB}$ is expressed in μm and $V_{BO}$ in volt.

The equations (1) and (2), obtained by evaluation of experiments, are represented in Fig. 4 by curves 200 and 300 respectively whereby the curve 200 shows the lower border line and the curve 300 shows the upper border line for a safe operation of a GTO thyristor with substantially no snubber circuit. The area between the lines 200 and 300 of Fig. 4 corresponds therefore to the hatched area in Fig. 2, that is, a GTO thyristor having the relation between the thickness $W_{nB}$ of the second layer 3 and the breakover voltage $V_{BO}$ according to the values within the area between the curves 200 and 300 in Fig. 4 exhibits a relation between the forward sustain voltage $V_{DRM(SUS)}$ and the breakover voltage $V_{BO}$ as indicated by the hatched area in Fig. 2 whereby in Fig. 2 the upper line corresponds to the curve 300 and the lower line to the curve 200 of Fig. 4 respectively. The thickness $W_{nB}$ of the GTO thyristor according to the invention which needs no snubber circuit is therefore determined by the following condition:

$$3.817\times10^{-1} \cdot V_{BO}-2.550\times10^{-4} \cdot V_{BO}^2+1.133\times10^{-7} \cdot V_{BO}^3$$

$$-2.000\times10^{-11} \cdot V_{BO}^4 \leq W_{nB} \leq 3.200\times10^{-1} \cdot V_{BO} \tag{3}$$

The snubber circuit considered to be substantially unnecessary has a capacitor of capacitance $C_s$ satisfying the following condition and a resistor of a resistance $R_s$ determined by the capacitance $C_s$:

$$\frac{1}{200} < \frac{V_{DRM(SUS)}}{i_s} \cdot C_s < \frac{1}{20}$$

3

where $V_{DRM(SUS)}$ is the forward sustain voltage and $i_s$ is the current upon turn-off switching. That is such a snubber circuit has practically negligible capacitance $C_s$ as it is used by the user.

With such a particular value of capacitance, the relation between the forward sustain voltage $V_{DRM(SUS)}$ and the breakover voltage $V_{BO}$ is kept within the shaded area in Fig. 2, and the forward sustain voltage increases, so that the GTO thyristor can operate with good switching characteristic under substantially no provision of a snubber circuit.

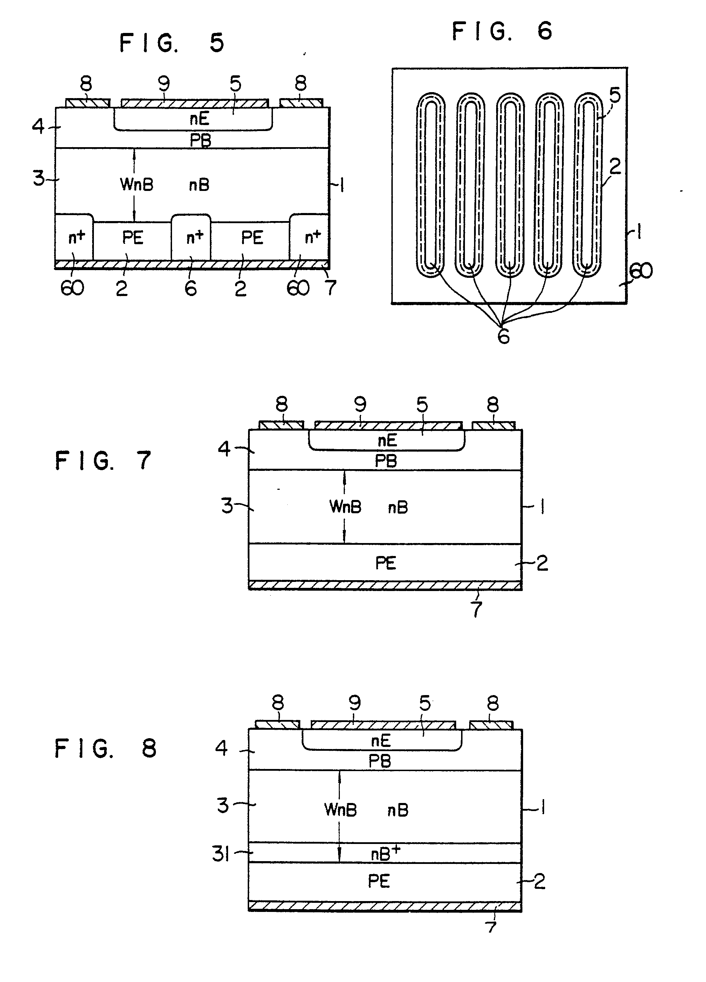

An embodiment of this invention will hereinafter be described with reference to Figs. 5 and 6.

Fig. 5 shows the cross-section of a unit GTO element constituting an anode emitter shorted GTO thyristor, and Fig. 6 is a plan of the anode electrode side of the GTO thyristor. This kind of GTO thyristor has in a semiconductor substrate 1 of P-type conductivity, an anode emitter ($P_E$) layer 2, a second base ($n_B$) layer 3 of n type conductivity, a first base ($P_B$) layer 4 of P-type conductivity, and a cathode emitter ($n_E$) layer 5 of n-type conductivity. The anode emitter layer 2 is shorted to an anode electrode made in low-resistance contact with the lower side main surface of the substrate 1 through anode-emitter shorting ($n^+$) layers 6 and 60 (which are part of the second base layer 3) of n-type conductivity which has a high-impurity concentration and exposed at the lower side main surface. The first base layer 4 and cathode emitter layer 5 are made in low-resistance contact with the control electrode 8 and the cathode electrode 9, respectively.

The cathode emitter layer 5 has the so-called planar junction structure in which the pn junction end is exposed at the upper side main surface of the semiconductor substrate 1. The anode emitter layer 2 is at a position to which the exposed pn junction end of the cathode emitter layer 5 is vertically projected toward the anode electrode 7, and the anode emitter shorting layer 6 is at a position to which the center portion of the cathode emitter layer 5 is vertically projected toward the anode electrode 7. The anode emitter layer 2 may be extended over the region to which the whole of the cathode emitter layer 5 is vertically projected toward the anode electrode 7. The actual GTO thyristor has a plurality of unit GTO elements one of which is shown in Fig. 5, provided in the semiconductor substrate 1 with common first base layers 4 and second base layers 3. In other words, when viewing the whole of the semiconductor substrate 1, the cathode emitter layers 5 appear to be in a plurality of separated strips, each being surrounded by control electrodes 8. The current capacity of the GTO thyristor can be determined by the number of these units GTO elements.

In Fig. 5, the thickness $W_{nB}$ of the second base layer 3 is determined by the special relationship with the breakover voltage $V_{BO}$ of the GTO thyristor as shown by Eqs. (3) and (4).

Figs. 7 and 8 show second and third embodiments of the unit GTO thyristor according to this invention, in which like parts corresponding to those of Figs. 5 and 6 are identified by the same reference numerals.

Fig. 7 shows the case of not taking the anode emitter layer 2 shorting structure but instead doping gold to short the life time for achieving turn-off performance. Fig. 8 shows the case of also doping gold and taking a structure that when the breakover voltage is 1500V or above, the voltage drop between the anode electrode 7 and cathode electrode 9 can be prevented from abnormally increasing in the on-state. Hence, an n-type conductivity base region ($n_B^+$) 31 is provided between the second base layer 3 and the anode emitter layer 2, and has a higher impurity concentration than that of the second base layer 3.

Thus, this invention can be applied to not only the anode emitter shorting structure but also to the anode emitter nonshorting structure and in this case a lifetime killer may be doped. If each unit GTO thyristor is made according to this invention, the GTO thyristor comprising any number of such unit GTO elements can be operated properly.

While in the embodiment of Fig. 6 the cathode emitter layers are provided in separated parallel strips on a square-shaped semiconductor substrate 1 to be in parallel with the sides of the substrate, the cathode emitter layers may be of any shape. For example, on a circular semiconductor substrate, there can be radially arranged the strip-shaped cathode emitter layers or in a multiradial way, or there can be concentrically arranged concentric annular-shaped or arc-shaped cathode emitter layers.

Moreover, the control electrodes are not necessary to be provided at the same level on the upper main surface at which the cathode emitter layer is exposed. For example, grooves may be provided in the first base layer around each cathode emitter layer, the control electrode being formed in the bottoms of the grooves to be in low-resistance contact therewith and to surround each cathode emitter layer. In this case, the pn junction formed by the cathode emitter layer and the first base layer may take the so-called mesa-type structure in which they are exposed at the groove.

The embodiments will be further described in more detail.

An n-type silicon wafer having specific resistance of 30 $\Omega \cdot$ cm is prepared and a GTO thyristor as shown in Figs. 5 and 6 is produced. Although five cathode emitter layers are shown in Fig. 6, this GTO thyristor has actually 8 cathode emitter layers. The thickness of the anode emitter layer 2 is 57 μm, that of the anode emitter shorting ($n^+$) layer 6, 60 is 75 μm, that of the second base layer 3 is 270 μm, that of the first base layer 4 is 40 μm, and that of the cathode emitter layer 5 is 17 μm. The width and length of the layer 5 are 300 μm and 5.8 mm, respectively. The breakover voltage $V_{BO}$ of this GTO thyristor is 900V, and the forward sustain voltage $V_{DRM(SUS)}$ is 600V. This thyristor conducting with a current of 300A can be turned off with a gate current of 75A under the substantially snubber-less condition. In this connection, the conventional GTO thyristor of the same structure with a second base layer 3 having a thickness of about 130 μm requires a snubber circuit having a capacitor of 0.22 μF and a resistor of about 220 $\Omega$ in order that when a current of 200A is caused to flow in the thyristor, it can be turned off with a gate current of 50A.

According to this invention, the forward sustain voltage is large and the capacitance of a snubber

4

circuit to be usually connected in parallel with a GTO thyristor can be made very small, and therefore a circuit with a GTO thyristor can be arranged to be simple and small-sized.

**Claims**

1. A gate turn-off thyristor comprising:

(a) a semiconductor substrate (1) in which a cathode emitter layer (5), a first base layer (4), a second base layer (3) and an anode emitter layer (2) are formed in that order, adjacent ones of said layers having different conductivity from each other to form pn junctions therebetween;

(b) said cathode emitter layer (5) being divided into cathode emitter layer portions each of which is exposed at one of the main surfaces of said semiconductor substrate (1);

(c) said anode emitter layer (2) being exposed at the other main surface of said semiconductor substrate (1);

(d) each of said separated cathode emitter layer portions (5) being made in low resistive contact with a cathode electrode (9);

(e) said first base layer (4) being made in low resistive contact with a control electrode (8) formed to surround each of said separated cathode emitter layer portions (5); and

(f) said anode emitter layer (2) being made in low resistive contact with an anode electrode (7); characterized in

that said second base layer (3) has a thickness $W_{nB}[\mu m]$ determined by the following condition:

$$3.817 \times 10^{-1} . V_{BO} - 2.550 \times 10^{-4} . V_{BO}^2$$

$$+ 1.133 \times 10^{-7} . V_{BO}^3 - 2.000 \times 10^{-11} . V_{BO}^4$$

$$\leq W_{nB} \leq 3.200 \times 10^{-1} . V_{BO}$$

where $V_{BO}[V]$ is a breakover voltage given when the anode electrode (7) and the cathode electrode (9) are supplied wihh a positive and a negative bias voltage, respectively.

2. A gate turn-off thyristor according to Claim 1, wherein said anode emitter layer (2) is shorted by said second base layer (3) and said anode electrode (7).

3. A gate turn-off thyristor according to Claim 1, wherein said second base layer (3) has a base region of the same conductivity and a higher impurity concentration on the anode emitter layer (2) side.

**Patentansprüche**

1. Abschaltbarer Thyristor, umfassend:

(a) ein Halbleitersubstrat (1), in dem eine Emitterkathodenschicht (5), eine erste Basisschicht (4), eine zweite Basisschicht (3) und eine Emitteranodenschicht (2) in dieser Reihenfolge gebildet sind, wobei benachbarte Schichten jeweils verschiedene Leitfähigkeit unter Bildung von pn-Übergängen zwischen den Schichten;

(b) wobei die Emitterkathodenschicht (5) in Emitterkathodenschichtbereiche unterteilt ist, von denen jeder an einer der Hauptflächen des Halbleitersubstrats (1) freiliegt;

(c) wobei die Emitteranodenschicht (2) an der anderen Hauptfläche des Halbleitersubstrats (1) freiliegt;

(d) wobei jeder der getrennten Emitterkathodenschichtbereiche (5) in niederohmigem Kontakt mit einer Kathode (9) liegt;

(e) wobei die erste Basisschicht (4) in niederohmigem Kontakt mit einer Steuerelektrode (8) liegt, die so ausgebildet ist, daß sie jeden der getrennten Emitterkathodenschichtbereiche (5) umgibt; und

(f) wobei die Emitteranodenschicht (2) in niederohmigem Kontakt mit einer Anode (7) liegt; dadurch gekennzeichnet,

daß die zweite Basisschicht (3) eine Dicke $W_{nB}[\mu m]$ hat, die durch die folgende Bedingung gegeben ist:

$$3,817 \times 10^{-1} . V_{BO} - 2,550 \times 10^{-4} . V_{BO}^2$$

$$+ 1,133 \times 10^{-7} . V_{BO}^3 - 2,000 \times 10^{-11} . V_{BO}^4$$

$$\leq W_{nB} \leq 3,200 \times 10^{-1} . V_{BO}$$

wobei $V_{BO}[V]$ eine Kippspannung ist, die sich einstellt, wenn der Anode (7) bzw. der Kathode (9) eine positive bzw. eine negative Vorspannung zugeführt wird.

2. Abschaltbarer Thyristor nach Anspruch 1, wobei die Emitteranodenschicht (2) durch die zweite Basisschicht (3) und die Anode (7) kurzgeschlossen ist.

3. Abschaltbarer Thyristor nach Anspruch 1, wobei die zweite Basisschicht (3) eine Basiszone mit der gleichen Leitfähigkeit und einer höheren Störstellendichte auf der Seite der Emitteranodenschicht (2) aufweist.

5

**Revendications**

1. Thyristor commandé par la gâchette, comprenant

(a) un substrat semiconducteur (1), dans lequel une couche d'émetteur de cathode (5), une première couche de base (4), une seconde couche de base (3) et une couche d'émetteur d'anode (2) sont formées dans cet ordre, des couches adjacentes appartenant auxdites couches possédant des conductivités différentes l'une de l'autre de manière à former entre elles des jonctions pn;

(b) ladite couche d'émetteur de cathode (5) étant subdivisée en des parties de la couche d'émetteur de cathode, dont chacune est exposée sur l'une des surfaces principales dudit substrat semiconducteur (1);

(c) ladite couche émetteur d'anode (2) étant exposée au niveau de l'autre surface principale dudit substrat semiconducteur (1);

(d) chacune desdites parties séparées (5) de la couche d'émetteur de cathode établissant un contact de faible valeur résistive avec une électrode formant cathode (9);

(e) ladite première couche de base (4) établissant un contact de faible valeur résistive avec une électrode de commande (8) formée de manière à entourer chacune desdites parties séparées (5) de la couche d'émetteur de cathode; et

(f) ladite couche d'émetteur d'anode (2) établissant un contact de faible valeur résistive avec une électrode formant anode (7);

caractérise en ce que

ladite seconde couche de base (3) possède une épaisseur $W_{nB}[\mu m]$ déterminée par la condition suivante:

$$3{,}817 \times 10^{-1} \cdot V_{BO} - 2{,}550 \times 10^{-4} \cdot V_{BO}^2$$

$$+1{,}133 \times 10^{-7} \cdot V_{BO}^3 - 2{,}000 \times 10^{-11} \cdot V_{BO}^4$$

$$\leq W_{nB} \leq 3{,}200 \times 10^{-1} \cdot V_{BO}$$

dans laquelle $V_{BO}[V]$ est une tension de claquage donnée lorsque l'électrode formant anode (7) et l'électrode formant cathode (9) sont alimentées respectivement par une tension de polarisation positive et une tension de polarisation négative.

2. Thyristor commandé par la gâchette selon la revendication 1, dans lequel ladite couche d'émetteur d'anode (2) est court-circuitée par ladite seconde couche de base (3) et par ladite électrode formant anode (7).

3. Thyristor commandé par la gâchette selon la revendication 1, dans lequel ladite seconde couche de base (3) possède une région de base possédant le même conductivité et une concentration d'impureté supérieure sur le côté de la couche d'émetteur d'anode (2).

0 066 721

F I G. 1

F I G. 2

F I G. 3

F I G. 4

FIG. 5

FIG. 6

FIG. 7

FIG. 8